# EUROPEAN PATENT SPECIFICATION

(11) **EP 2 250 683 B1**
(45) Date of publication and mention of the grant of the patent: **13.11.2013**
(21) Application number: 08715688.1
(22) Date of filing: 04.02.2008
(51) Int. Cl.: H01L 41/113, G01L 5/16

(54) **SENSOR ELEMENT**
SENSORELEMENT
ELÉMENT CAPTEUR

(43) Date of publication of application: 17.11.2010
(73) Proprietor: AB SKF, 415 50 Göteborg (SE)
(72) Inventor: ZHOU, Xiao, Bo, NL-3994 PV Houten (NL)
(74) Representative: Burö, Sven Peter
(86) International application number: PCT/EP2008/000863
(87) International publication number: WO 2009/097867

(56) References cited:
- DE-A1- 10 313 060
- JP-A- 6 112 543
- JP-A- 2000 351 212
- JP-A- 2001 210 888
- JP-A- 2007 003 443

## Description

### TECHNICAL FIELD

The invention concerns a sensor element for sensing load and vibration in a component such as a rolling element bearing and is more particularly directed to a sensor element which comprises a multilayer coating.

### BACKGROUND

Bearings are used in many different types of machinery to retain and support rotating components such as, for example, a wheel on a vehicle, a vane on a windmill or a drum in a washing machine. During use, the bearing is subjected to different loads, both static and dynamic. The static load is due to the weight supported by the bearing, and may also be due to a preload with which the bearing is mounted. The dynamic loads are time dependent and are due to the operating conditions.

In many systems, it is desirable to be able to monitor the load acting on a bearing. In modern vehicles, for example, load data from the wheel bearings are used in the control of vehicle stability systems. Vibration is another physical parameter that is important with regard to bearings, as it provides an indication of the 'health' of a bearing. Excessive vibration may be a sign that a bearing is nearing the end of its life, and so bearings in vital machinery are often provided with sensors to monitor vibration.

Many examples of bearings provided with sensors are known in the art. Displacement sensors such as strain gauges are commonly applied to measure load and deformation, while thin film piezoelectric transducers may be used as vibration sensors. Preloaded piezoelectric sensors can also be used as displacement sensors.

A preloaded piezoelectric sensor needs to be clamped to a component surface. The clamping means takes up space and such a sensor is unsuitable for use on rotating parts. Strain gauges may be attached to a surface of a rotating part, such as a bearing inner or outer ring. The most widely applied method of attachment is adhesive bonding, which is both a delicate process as well as a time-consuming process, as the adhesive may need several hours to cure. Also, the surface cleanliness requirements for effective adhesion are incompatible with many production environments. Consequently there is a need for a sensor element that is easy to affix to a component surface.

Applications also exist, however, which are unsuited to the use of mounted sensor elements. For example, on component surfaces where it is important that the surface topography remains substantially unchanged, or where there is very little space, or where the sensor is subjected to high tribological stresses.

A sensor element that can be deposited on the surface of a component in the form of a coating overcomes these difficulties. Such a coating is known from DE10313060, which discloses a tribological layer comprising a piezoresistive element. The resistance of a piezoresistive element changes when the element is deformed, and load can thus be determined by measuring the resistance.

In JP 2000351212 a piezoelectric element is disclosed which comprises a piezoelectric film formed on a lower electrode, an insulating substance formed on the piezoelectric film and an upper electrode formed on the piezoelectric film. The insulating substance is back-etched after it is formed on the piezoelectric film, such that only defective parts of the piezoelectric film are filled.

There is still room for improvement, however, in terms of accuracy, reliability and range of applications.

### SUMMARY

An object of the invention is therefore to define a sensor element which is capable of sensing load and/or vibration and which produces an accurate, strong and reliable signal.

A further object of the invention is to define a sensor element suitable for direct integration on a component of, for example, a rolling element bearing, which can be integrated on any surface without affecting the operation of the bearing.

A still further object of the invention is to define a sensor element that is also suitable for attachment on a component of, for example, a rolling element bearing by means of a straightforward procedure

The present invention also defines a method of producing such a sensor element.

The aforementioned objects are achieved according to the invention by a sensor element which comprises a multilayer coating deposited on a substrate, where the coating comprises a sensitive layer of a piezoelectric material and a first electrode layer of a metallic material, which electrode layer serves as a first electrode of the sensor element. The sensitive layer is located between the first electrode and a second electrode of the sensor element, where the second electrode is formed by the substrate or by a second electrode layer of the multilayer coating. In order to seal any pinholes in the sensitive layer and thereby prevent short-circuiting between the first and second electrodes, the multilayer coating further comprises a pinhole sealing layer deposited on top of the sensitive layer.

In a first embodiment of the invention, the substrate is formed by a surface of a metallic component, such as a raceway surface of a rolling element bearing. In this embodiment, the metallic substrate may serve as the second electrode. A preferred material for the sensitive layer is aluminium nitride, which is a hard and wear-resistant material and is therefore advantageous to use in a coating that could be subject to high tribological stresses. It also has excellent piezoelectric properties when deposited or "grown" with a crystallographic orientation that predominantly lies in the c-axis, <002> direction, i.e. perpendicular to the surface on which it is grown. A preferred method of depositing the aluminium nitride layer is by means of a physical vapour deposition process and, more preferably, by means of reactive sputtering. Reactive sputtering is advantageous, since the process parameters involved can be accurately controlled in order to obtain optimal c-axis orientation.

An aluminium nitride piezoelectric layer has further advantages. It is self-polarizing and thus does not require polarization after deposition. Aluminium nitride also produces a strong signal with an excellent linear response when subjected to mechanical deformations. Moreover, the linear response is produced over a wide frequency range which extends from the sub-Hz range up to the Mega-Hz range. In the case of a rolling element bearing, the frequency of the time-varying loads on a bearing ring due to the passage of rolling elements is in the order of the rotational frequency of the bearing, e.g. 10 - 1000 Hz. If the bearing develops a surface defect such as a raceway crack or spall, the frequency of the vibrations generated is in the order of 10 to 100 times the rotational frequency of the bearing. A sensor element according to the invention is therefore cable of sensing dynamic loads and vibrations in a component. The invention is not restricted to the use of aluminium nitride, however; zinc oxide oriented in the <002> direction is another suitable piezoelectric material.

The piezoelectric layer is deposited in a thickness of less than 10 µm, with a preferred thickness of between 0.5 and 2 µm. Aluminium nitride and piezoelectric crystals in general are porous materials. At such small thicknesses, it becomes likely that the piezoelectric layer will contain pinholes, also in view of the fact that the layer thickness is in the same order of magnitude as the surface roughness of the surface on which the aluminium nitride is deposited. When the first electrode layer is deposited on the piezoelectric layer by means of a physical vapour deposition process, there is then a risk of metal atoms penetrating through the pinholes, which would lead to short-circuiting between the first and second electrodes and failure of signal generation.

Thus, according to the invention, a pinhole sealing layer is deposited on top of the piezoelectric layer, between the piezoelectric layer and the electrode layer. The pinhole sealing layer is an ultra-thin film of a dielectric material, which seals the pores in the piezoelectric layer without substantially adding to the thickness of the piezoelectric layer. The thickness of the pinhole sealing layer is less than 10% of the thickness of the piezoelectric layer, and is preferably less than 5% of the thickness of the piezoelectric layer. A material that may suitably be used for the pinhole sealing layer is aluminium oxide. The pinhole sealing layer is deposited with a preferred thickness of between 0.01 and 0.1 µm.

A pinhole sealing layer of aluminium oxide may also be deposited by means of a physical vapour deposition process. Reactive sputtering is a preferred method. This is advantageous as the pinhole sealing layer can be deposited in the same chamber of the equipment in which the piezoelectric layer is deposited, thereby contributing to time and cost savings. In an alternative method, the aluminium oxide layer may be provided by means of atomic layer deposition (ALD). In this process, alternate pulses of an aluminium precursor and an oxygen precursor are injected into the reaction chamber. In a first step of a cycle, aluminium precursor molecules are deposited on the exposed substrate surface. Typically, a purge gas is then injection into the chamber to remove excess precursor. In the next step, oxygen precursor molecules are deposited, which react with the aluminium molecules to form an atomic layer of aluminium oxide. The cycle is completed with a further injection of purge gas to remove unreacted precursor. Each cycle leads to the formation of a single atomic layer of aluminium oxide, and the thickness of a film can be controlled with extreme precision via the number of cycles. Using atomic layer deposition, the aluminium oxide pinhole sealing layer may be deposited in extremely small thicknesses from 0.001 µm up to e.g. 0.1 µm. A further advantage of atomic layer deposition is that the deposited film is highly conformal.

The pinhole sealing layer prevents short-circuiting between the electrodes of the sensor element. The first electrode consists of a metallic layer of e.g. nickel or copper, which is deposited on top of the pinhole sealing layer In a preferred thickness of between 0.1 and 2 µm. The electrode layer may be deposited by means of a physical vapour deposition process, and sputtering is again a preferred method.

In an advantageous development of the invention, the multilayer coating comprises a metallic bond layer that is deposited immediately prior to deposition of the piezoelectric layer. The bond layer improves the adhesion of the piezoelectric layer. Materials that may suitably be used for the bond layer are molybdenum and chromium. Again for reasons of cost and time savings, the bond layer is preferably deposited by means of sputtering. The bond layer may have a thickness of less than 1 µm, with a preferred thickness of between 0.05 and 0.5 µm.

The multilayer coating may further comprise an insulation layer that is deposited on top of the first electrode layer. This prevents the transfer of electrical charge to conductors that come in contact with the sensor element. The insulation layer may be an aluminium oxide layer or an amorphous (i.e. non-piezoelectric) aluminium nitride layer deposited in a thickness of between 0.05 and 10 µm by means of a physical vapour deposition process. Reactive sputtering is once again preferred, to enable production of the entire multi-layer coating in the same process chamber.

When the substrate is a metallic surface of a component, the substrate may serve as the second electrode or, alternatively the multilayer coating may comprise a second electrode layer deposited prior to the piezoelectric layer. In this latter case, the multilayer coating suitably comprises an insulation layer between the metallic substrate and the second electrode layer. An insulation layer as described above may suitably be used. The multilayer coating of the inventive sensor element may comprise further layers of shielding, in order to comply with applicable electrical insulation requirements. Moreover, in applications where the coating is subject to high tribological stresses, an anti-wear coating such as a diamond-like carbon (DLC) coating may be provided on top of the insulation layer, to protect the insulation layer and improve the overall wear resistance of the inventive sensor element.

Thus, the multilayer coating of the Inventive sensor element may have an overall thickness of less than 20 µm and is suitable for deposition on surfaces of mechanical components that are subject to dynamic loads and tribological stresses. One application of the sensor coating according to the invention is on component surfaces of a rolling element bearing. For the measurement of bearing load/deformation, the sensor coating could be deposited on the outer circumference of a bearing outer ring or the bore of a bearing inner ring. For the measurement of contact stress, the multilayer coating could be deposited on a bearing raceway or on a rolling element. The inventive sensor element can also be used to monitor vibrations in a bearing when the multilayer coating is applied on any of the aforementioned surfaces.

A sensor element according to the invention is not restricted to bearing applications, however. The substrate could be formed by a surface or surfaces of other metallic components that are subject to dynamic loads and tribological stresses, such as gear teeth and machine tools. Neither is the inventive sensor element restricted to direct integration (deposition) on a component surface.

In a second embodiment of the invention, the substrate may be formed by a surface of a carrier element, which carrier is attached to a surface of a component. If the surface of the carrier is a non-conductor, an electrode layer must be deposited to serve as the second electrode of the sensor element. If the surface of the carrier element is electrically conductive, this surface may serve as the second electrode. In this latter case, the carrier preferably consists of a sheet of metallic material, with a thickness of less than 0.5 mm. The metallic carrier is therefore flexible, which is advantageous as the inventive sensor element can be bent to follow the curvature of a curved component such as a bearing outer ring. Steel and stainless steel are suitable materials for the carrier element, as they possess the necessary strength and flexibility. A further important advantage is that a suitable steel or stainless steel carrier enables the sensor element to be welded to a steel component, such as bearing ring. A welding process is a faster and more economical means of attachment than e.g. adhesive bonding. A sensor element according to the second embodiment of the invention may be mounted on e.g. the outer circumference of a bearing outer ring or the bore of an inner ring, to measure loads and/or vibrations.

The present invention also defines a method of producing a sensor element, where the sensor element comprises a multilayer coating deposited on a substrate, the method comprising the steps of:
(i) depositing a sensitive layer of piezoelectric material;
(ii) depositing a pinhole sealing layer on top of the sensitive layer;
(ii) depositing an electrode layer on top of the pinhole sealing layer.

Examples of the inventive sensor element's uses and further advantages will become apparent from the detailed description and accompanying drawings.

### BRIEF DESCRIPTION OF THE DRAWINGS

The invention will now be described in more detail for explanatory and in no sense limiting purposes with reference to the following figures, in which
- Fig.1: illustrates an example of a rolling element bearing;
- Fig.2: illustrates a sectional view of part of a mechanical component provided with a sensor element according to a first embodiment of the invention;
- Fig.3: illustrates a layer-by-layer composition of a multilayer coating according to a second embodiment of the invention.
- Fig.4: illustrates a flowchart of a method by which the multilayer coating of Fig. 3 may be produced.

### DETAILED DESCRIPTION

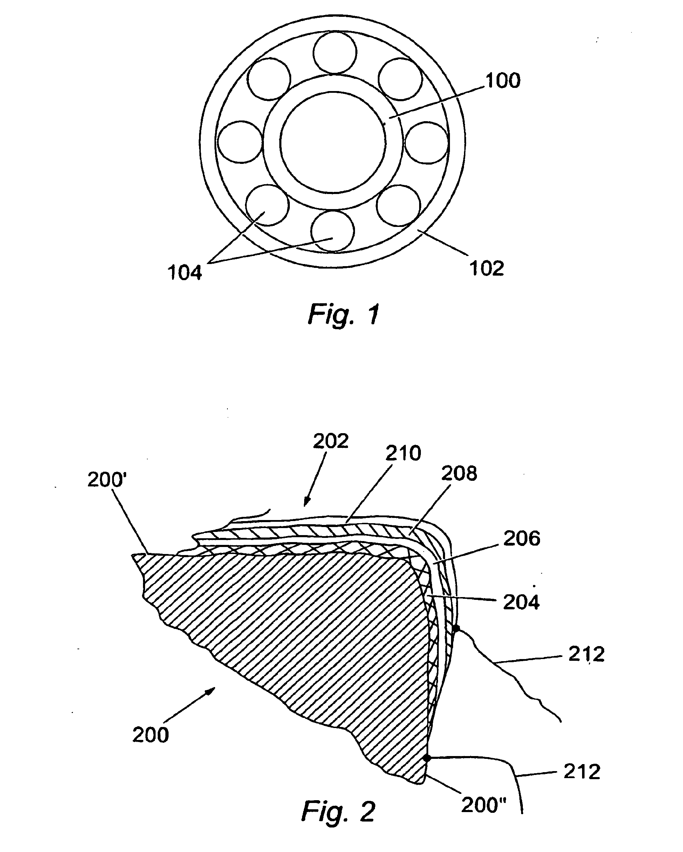

Fig. 1 illustrates an example of a rolling element bearing. The bearing comprises an inner ring 100 and an outer ring 102 rotatably coupled by means of rolling elements 104. The rolling elements are disposed between the Inner and outer rings on at least one set of opposing raceways. Many applications exist where it is desirable to determine the loads acting on a bearing. A common way of doing this is to mount one or more displacement sensors on e.g. an outer circumference of the outer ring 102, to measure deformation of the outer ring and calculate the bearing loads therefrom. Such sensors would be destroyed if mounted on, for example, a bearing raceway. However, sensor elements placed on a bearing raceway would provide valuable information about contact stresses that occur when a bearing is in operation. This information can be obtained by means of a sensor element according to the invention, which comprises a wear-resistant multilayer coating that can be deposited directly on a mechanical component in a thickness of less than 50 microns.
Fig. 2 shows a sectional view of part of a mechanical component 200 that has been provided with a sensor element according to a first embodiment of the invention. The mechanical component could be, for example, an Inner ring of a rolling element bearing, where the sensor element is intended to measure contact stresses on an inner ring raceway. The sensor element comprises a multilayer coating 202, which coating comprises a piezoelectric layer 204 deposited on substrate formed by a raceway surface 200' and a perpendicular surface 200" of the inner ring 200. The multilayer coating 202 further comprises an electrode layer 208, which serves as a first electrode. The substrate (200', 200") serve as the second electrode in the illustrated example. Suitable, the first electrode has a circumferential length of less than the distance between the points at which two adjacent rolling elements make contact with the raceway surface 200', to ensure that only one rolling element at a time can cause the piezoelectric layer to deform. To insulate the first electrode 208 from contact with electrical conductors, an insulation layer 210 may be deposited on top of the electrode layer 208. The measurement application in this example entails that the sensor element will be subject to high tribological stresses, in which case it may be advantageous to provide the sensor element with an anti-wear coating (not shown) on top of the insulation layer 210.

During operation of the bearing, the rolling elements overroll the coated raceway surface 200' on the inner ring, causing mechanical deformation of the piezoelectric layer 204. This mechanical deformation produces a proportional change in the electric polarization of the piezoelectric layer. The sensor output is therefore an electric charge generated between the first and second electrodes, which charge is proportional to the mechanical deformation. One way of measuring the sensor output is by coupling the first and second electrodes to an appropriate charge amplifier by means of sensor connections 212. The charge amplifier suitably convents the electric charge output to a voltage output. Thus, a voltage signal may be produced during bearing operation which, with the aid of suitable processing means, can be used to determine the contact stresses.

Because the coating may be subject to high stresses, the piezoelectric layer 208 in this embodiment of the invention preferably consists of aluminium nitride that is deposited with a crystallographic orientation which predominantly lies in the c-axis, <002> direction, i.e. perpendicular to the surface on which it is deposited. This orientation ensures optimal piezoelectric properties, and aluminium nitride also possesses the necessary robustness. Another advantage of aluminium nitride is that it is self-polarizing and does not require subsequent polarization to enhance the piezoelectric effect. A drawback of aluminium nitride is that it is porous. To be suitable for integration on e.g. a bearing raceway, the piezoelectric layer 204 is preferably deposited in a thickness of less than 5 µm. At such small layer thicknesses, there is a risk that the piezoelectric layer 204 will contain pinholes. Such pinholes could allow short-circuiting between the first and second electrodes, leading to signal failure.

According to the invention, this difficulty is overcome by depositing a pinhole sealing layer 206 on top of the piezoelectric layer 204, prior to deposition of the electrode layer 208. The pinhole sealing layer 206 is an ultra-thin film of a dielectric material, which seals the pores in the piezoelectric layer without substantially adding to the thickness of the piezoelectric layer. Suitably, the thickness of the pinhole sealing layer 206 is less than 10% of the thickness of the piezoelectric layer 204 and is preferably less than 5% of the thickness of the piezoelectric layer. The pinhole sealing layer 206 preferably consists of aluminium oxide deposited in a thickness of between 0.01 and 0.1 µm. A sensor element according to the first embodiment of the invention therefore takes up very little space and produces a highly reliable signal.

As shown in Fig. 2, the multilayer coating 202 may be provided such that it extends over more than one surface of the component 200. With reference to the example of a bearing inner ring, the coating extends from the raceway surface 200' of the inner ring to a perpendicular surface 200" of the inner ring, where the sensor connections 212 are suitably attached to the first and second electrodes. In the case of a bearing ring, realization of the sensor connections between the first and second electrodes and e.g. the charge amplifier is much more straightforward when the connections are made at this perpendicular surface 200". This is particularly true if the bearing ring rotates during operation. In this case, the sensor connections between the first and second electrodes and the charge amplifier may be achieved by means of e.g. slip rings.

Thus, the multilayer coating 202 of a sensor element according to the invention may be deposited on surfaces of rotatable components. These surfaces include the inner and/or outer circumference of a bearing outer ring, the inner and/or outer circumferences of a bearing inner ring and even the surfaces of a rolling element. When deposited on a rolling element or on a bearing raceway, the piezoelectric layer 204 of the sensor element is subjected to compression and the piezoelectric effect is generated in d33 mode, meaning that the applied force is parallel to the direction of polarization. When deposited on an outer circumference of a bearing outer ring or the bore of a bearing inner ring, the piezoelectric layer bends as a result of deformation of the bearing ring due to the passage of rolling elements. Thus, the local bending component of the total movement of the piezoelectric layer will cause a difference in the strains induced on either side of the piezoelectric layer. The resulting forces act in a direction transverse to the direction of polarization, and piezoelectric effect is thus generated in d31 mode.

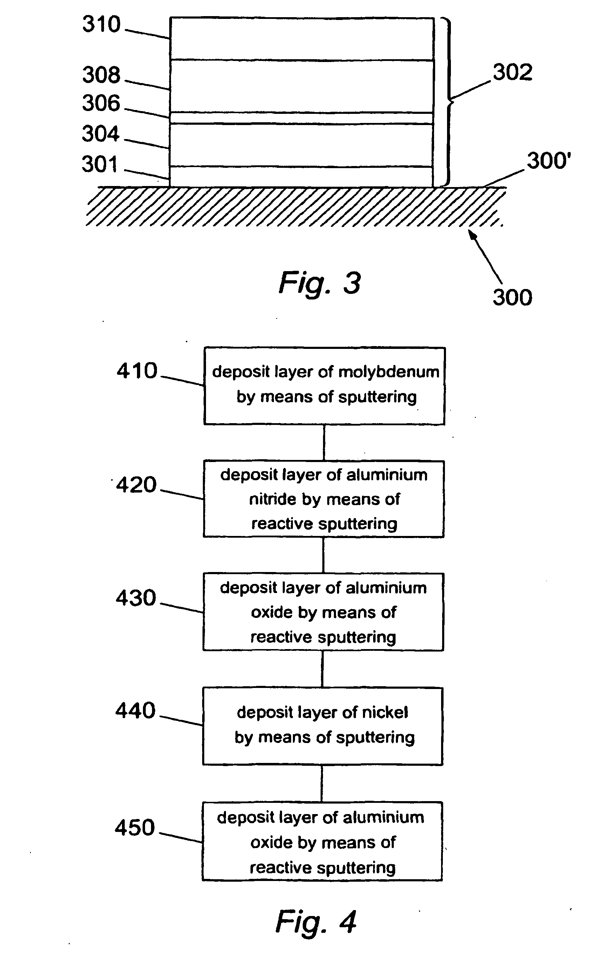

As well as being suitable for direct integration on a component, a sensor element according to the invention may also be integrated on a carrier element, which carrier element is then attached to the component on which measurements are to be performed. Fig. 3 illustrates a second embodiment of a sensor element according to the invention, where the multilayer coating is deposited on a surface 300' of a metallic carrier 300, such as a thin sheet of stainless steel e.g. AISI 304 or AISI 316L. The carrier 300 may serve as the second electrode. The multilayer coating 302 shown in Fig. 3 comprises a piezoelectric layer 304, a pinhole sealing layer 306, a first electrode layer 308, and an insulation layer 310, where the individual layers are deposited in this sequence. In this embodiment, and in the first embodiment, the multilayer coating 302 may further comprise a metallic bond layer 301, which is deposited immediately prior to deposition of the piezoelectric layer 304. The bond layer 301 improves the adhesion of the piezoelectric layer 304, thereby improving the reliability and accuracy of the sensor element. Suitable materials for the bond layer include molybdenum and chromium.

The multilayer coating 302 may also be deposited on a non-metallic substrate, in which case a second electrode layer of e.g. copper or nickel would be deposited prior to deposition of the piezoelectric layer 304, to serve as the second electrode. The multilayer coating may also comprise a second electrode layer to serve as the second electrode when the coating is deposited on a metallic substrate (on a metallic carrier element or on a component surface). Suitably, a further insulation layer is then deposited between the substrate 300' and the second electrode layer. Further layers of shielding may also be provided.

A carrier element 300 made of a sheet of e.g. stainless steel, with a thickness of less than 500 µm is flexible, strong and corrosion resistant. A sensor element that comprises such a thin metal sheet is therefore also flexible and resilient. This is particularly advantageous if the sensor element is to be mounted on a curved component, such as a bearing outer ring. The sensor element can then be made to follow the curvature of e.g. the bearing ring. A further advantage of a carrier element 300 made from stainless steel or other steel material is that the sensor element is then suitable for welding to a steel component. When the steel component is a bearing, suitable materials for the carrier element 300 include steels with no more than 0.2 wt.% carbon, nickel and nickel alloys, titanium and titanium alloys. For example, a sensor element according to the second embodiment of the invention could be mounted in a circumferential direction on a bearing outer ring and affixed by means of spot welding a first and second longitudinal end of the carrier to the surface of the bearing outer ring. Such a joining process is much faster and more economical than e.g. adhesive bonding.

Thus, a multilayer coating of a sensor element according to the invention may be deposited on one or more surfaces of a machine component or on a surface 300' of e.g. a thin and flexible metallic carrier. The multilayer coating may have a thickness of less than 50 µm, with typical values of between 10 and 20 µm. The individual layers of the coating, of course, have even smaller thickness values. A suitable method of achieving such thin-film layers is by means of a physical vapour deposition process. A preferred method of producing one example of a multilayer coating of a sensor element according to the invention will now be described with reference to Fig. 3 and the flowchart of Fig. 4.

In a first step 410, the metallic bond layer 301 is deposited on the metallic substrate 300 (which substrate can also be a surface of e.g. a bearing ring). A molybdenum target is sputtered in an inert gas environment, leading to the formation of a molybdenum film on the metallic substrate 300. The film preferably has a thickness of less than 1 µm, where 0.1 µm is a typical value.

In a second step 420, the piezoelectric layer 304 is deposited on the bond layer 301 by means of reactive sputtering. A pure aluminium target is sputtered in a nitrogen-containing environment, leading to the formation of an aluminium nitride film on the bond layer 301. The aluminium nitride film 304 has a thickness of less than 10 µm, with a preferred value of between 0.5 and 2 µm. During this step of the process, the process parameters are controlled to ensure that the aluminium nitride is formed with a crystallographic orientation which predominantly lies in the c-axis.

In a third step 430, the pinhole sealing layer 306 is deposited on the piezoelectric layer 304 by means of reactive sputtering. A pure aluminium target is sputtered in an oxygen-containing environment, leading to the formation of an aluminium oxide film on the piezoelectric layer 304. The aluminium oxide film may have a thickness of less than 0.5 µm with a preferred value of between 0.01 and 0.1 µm.

In a fourth step 440, the electrode layer 408 is deposited on the pinhole sealing layer 306. A nickel target is sputtered In an inert gas environment, leading to the formation of a nickel film on the pinhole sealing layer 308. The nickel film may have a thickness of less than 5 µm, with a preferred value of between 0.1 and 2 µm. During the deposition, suitable masks are used to enable an electrical connection from the electrode layer 408 to be made.

In a fifth step 450, the insulation layer 410 is deposited on the electrode layer 308 by means of reactive sputtering. A pure aluminium target is sputtered in an oxygen-containing environment as described above for the third step. The resulting aluminium oxide insulation layer has a thickness of less than 10 microns, with a preferred value of between 0.1 and 1 µm.

The above process may be carried out in commercially available sputter deposition equipment. Magnetron sputtering or RF sputtering, for example, may be applied. An advantage of the sputtering technique is that the entire multilayer coating of the sensor element may be deposited in the same chamber of the process equipment, thereby saving time and costs. According to an alternative method and embodiment of the sensor element, the aluminium oxide sealing layer may be provided by means of atomic layer deposition.

A sensor element according to the invention can be used to determine loads in a component such as a rolling element bearing. The sensor element produces a strong signal with an excellent linear response over a wide frequency range. Loads/deformations of a bearing ring - due to the passage of the rolling elements - may be measured by applying the sensor element on e.g. an inner circumference of the inner ring and suitably filtering the signal produced. The cut-off frequency is selected depending on the application conditions, e.g. speed of rotation. The inventive sensor element could also be used on a hub bearing unit. For example, an inboard side of the hub mounting flange could be provided with a multilayer coating according to the invention, to detect loads between the flange and the part to which it is affixed (e.g. a steering knuckle). In a further example, the coating could be provided on the flange radius at the outboard side of the hub mounting flange. This radius refers to an arcuate portion between the hub outer ring and the hub mounting flange, and a sensor element located here could be used to determine bending moment due to cornering forces.

A sensor element according to the invention may also be used for condition monitoring purposes, e.g. to monitor high-frequency vibrations in a rolling element bearing. For the sensing of vibrations, a higher cut-off frequency is suitably selected. As will be clear to persons skilled in the art, suitable pass-band filters and processing circuitry may be employed to process the sensor signal in the desired frequency range or ranges. Depending on the stiffness, damping and mass characteristics of the system in which the e.g. bearing is mounted, it may also be advantageous to filter out certain resonances from the system

Thus, a sensor element according to the invention may be used to sense dynamic loads and/or vibrations in a component. A sensor element according to the first embodiment of the invention is suitable for direct integration on one or more surfaces of the component. A sensor element according to the second embodiment of the invention may be quickly and easily affixed to the surface of a component

A number of aspects/embodiments of the invention have been described. It is to be understood that each aspect/embodiment may be combined with any other aspect/embodiment. Moreover the invention is not restricted to the described embodiments, but may be varied within the scope of the accompanying patent claims.

### REFERENCE NUMERALS

- Fig. 1: illustrates an example of a rolling element bearing,

- 100: bearing inner ring,
- 102: bearing outer ring,
- 104: rolling elements.

- Fig. 2: illustrates a sectional view of part of a mechanical component provided with a sensor element according to a first embodiment of the invention,

- 200: mechanical component (bearing inner ring),
- 200', 200": component surfaces (substrate),
- 202: multilayer coating,
- 204: piezoelectric layer,
- 206: pinhole sealing layer,
- 208: electrode layer,
- 210: insulation layer,
- 212: sensor connections.

- Fig.3: illustrates a layer-by-layer composition of a multilayer coating according to a second embodiment of the invention,

- 300: thin metallic sheet,
- 300': substrate,
- 301: bond layer,
- 302: multilayer coating,
- 304: piezoelectric layer,
- 306: pinhole sealing layer,
- 308: electrode layer,
- 310: insulation layer.

- Fig. 4: illustrates a flowchart of a method by which the multilayer coating of Fig. 3 may be produced,

- 410: deposit layer of molybdenum by means of sputtering,
- 420: deposit layer of aluminium nitride by means of reactive sputtering,
- 430: deposit layer of aluminium oxide by means of reactive sputtering,
- 440: deposit layer of nickel by means of sputtering,
- 450: deposit layer of aluminium oxide by means of reactive sputtering.

## Claims

1. A sensor element comprising a multilayer coating deposited on a substrate (200', 200", 300'), the multilayer coating (202, 302) comprising a sensitive layer (204, 304) of a piezoelectric material and a first electrode layer (208, 308) of a metallic material, which electrode layer serves as a first electrode of the sensor element, the sensitive layer being located between the first electrode and a second electrode of the sensor element, **characterized in that** the multilayer coating (202, 302) further comprises a pinhole sealing layer (206, 306), to seal any pinholes in the sensitive layer (204, 304) and thereby prevent short circuiting between the first and the second electrode, the pinhole sealing layer (206, 306) being of a dielectric material deposited on top of the sensitive layer (204, 304), so as to be sandwiched between the sensitive layer and the first electrode layer (208, 308), wherein the pinhole sealing layer (206, 306) has a thickness of less than 10% the thickness of the sensitive layer (204, 304).

2. A sensor element according to claim 1, wherein the thickness of the pinhole sealing layer (206, 306) is less than 5% the thickness of the sensitive layer (204, 304).

3. A sensor element according to claim 1 or 2, wherein the sensitive layer (204, 304) consists of aluminium nitride or zinc oxide, deposited with a crystallographic orientation predominantly lying in the c-axis, having a thickness of less than 10 µm.

4. A sensor element according to any of the preceding claims, wherein the pinhole sealing layer (206, 306) consists of aluminium oxide.

5. A sensor element according to any of the preceding claims, wherein the sensitive layer (204, 304) is deposited on the substrate (200', 200", 300').

6. A sensor element according to any of claims 1 to 4, wherein the multilayer coating (202, 302) further comprises a metallic bond layer (301) deposited on top of the substrate (200', 200", 300') immediately prior to the sensitive layer (204, 304).

7. A sensor element according to any of the preceding claims, wherein the substrate (200', 200", 300') is formed by a material that is an electrical conductor.

8. A sensor element according to any of the preceding claims, wherein the substrate (300') is a surface of a sheet-metal carrier (300) with a thickness of less than 500 µm.

9. A sensor element according to claim 8, wherein the sheet-metal carrier (300) is formed from a steel material comprising no more than 0.2 wt.% carbon, or from nickel or an alloy thereof or from titanium or an alloy thereof.

10. A sensor element according to any of claims 1 to 7, wherein the substrate (200', 200") is formed by a surface or surfaces of a mechanical component.

11. A sensor element according to claim 10, wherein the mechanical component is a component of a rolling element bearing or of a hub bearing unit.

12. A sensor element according any of claims 1 to 4, wherein the substrate is formed by a material that is an electrical insulator.

13. A sensor element according to any of claims 1 to 11, wherein the substrate (200, 200", 300') serves as the second electrode of the sensor element.

14. A sensor element according to any of the preceding claims, wherein the sensitive layer (204, 304) and the pinhole sealing layer (206, 306) are deposited by means of reactive sputtering.

15. A method of producing a sensor element according to any of the previous claims, where the sensor element comprises a multilayer coating (202, 302) deposited on a substrate, the method comprising the steps of:
(i) depositing a sensitive layer (204, 304) of a piezoelectric material;
(ii) depositing a pinhole sealing layer (206, 306) on top of the sensitive layer, in a thickness of less than 10% the thickness of the sensitive layer (204. 304);
(iii) depositing an electrode layer (208, 308) on top of the pinhole sealing layer.

## Patentansprüche

1. Sensorelement, das eine mehrlagige Beschichtung, die auf einem Substrat (200', 200", 300') aufgetragen ist, umfasst, wobei die mehrlagige Beschichtung (202, 302) eine empfindliche Schicht (204, 304) eines piezoelektrischen Materials und eine erste Elektrodenschicht (208, 308) eines metallischen Materials umfasst, wobei die Elektrodenschicht als eine erste Elektrode des Sensorelements dient, wobei die empfindliche Schicht zwischen der ersten Elektrode und einer zweiten Elektrode des Sensorelements angeordnet ist, **dadurch gekennzeichnet, dass**:
die mehrlagige Beschichtung (202, 302) ferner eine Nadellochabdichtungsschicht (206, 306) umfasst, um irgendwelche Nadellöcher in der empfindlichen Schicht (204, 304) abzudichten und dadurch einen Kurzschluss zwischen der ersten und der zweiten Elektrode zu verhindern, wobei die Nadellochabdichtungsschicht (206, 306) aus einem dielektrischen Material besteht, das auf die Oberseite der empfindlichen Schicht (204, 304) aufgetragen ist, um so zwischen der empfindlichen Schicht und der ersten Elektrodenschicht (208, 308) schichtenweise übereinander angeordnet zu werden, wobei die Nadellochabdichtungsschicht (206, 306) eine Dicke von weniger als 10 % der Dicke der empfindlichen Schicht (204, 304) aufweist.

2. Sensorelement nach Anspruch 1, wobei die Dicke der Nadellochabdichtungsschicht (206, 306) kleiner als 5 % der Dicke der empfindlichen Schicht (204, 304) ist.

3. Sensorelement nach Anspruch 1 oder 2, wobei die empfindliche Schicht (204, 304) aus Aluminiumnitrid oder Zinkoxid besteht, die mit einer kristallographischen Orientierung, die vorwiegend in der c-Achse liegt, mit einer Dicke von weniger als 10 µm aufgetragen ist.

4. Sensorelement nach einem der vorhergehenden Ansprüche, wobei die Nadellochabdichtungsschicht (206, 306) aus Aluminiumoxid besteht.

5. Sensorelement nach einem der vorhergehenden Ansprüche, wobei die empfindliche Schicht (204, 304) auf das Substrat (200', 200", 300') aufgetragen ist.

6. Sensorelement nach einem der Ansprüche 1 bis 4, wobei die mehrlagige Beschichtung (202, 302) ferner eine metallische Bindungsschicht (301) umfasst, die auf die Oberseite des Substrats (200', 200", 300') unmittelbar vor der empfindlichen Schicht (204, 304) aufgetragen ist.

7. Sensorelement nach einem der vorhergehenden Ansprüche, wobei das Substrat (200', 200", 300') aus einem Material ausgebildet ist, das ein elektrischer Leiter ist.

8. Sensorelement nach einem der vorhergehenden Ansprüche, wobei das Substrat (300') eine Oberfläche einer Trägermetallfolie (300) mit einer Dicke von weniger als 500 µm ist.

9. Sensorelement nach Anspruch 8, wobei die Trägermetallfolie (300) aus einem Stahlmaterial, das nicht mehr als 0,2 Gew.-% Kohlenstoff umfasst, oder aus Nickel oder aus einer Legierung davon oder aus Titan oder aus einer Legierung davon ausgebildet ist.

10. Sensorelement nach einem der Ansprüche 1 bis 7, wobei das Substrat (200', 200") durch eine Oberfläche oder durch Oberflächen einer mechanischen Komponente gebildet ist.

11. Sensorelement nach Anspruch 10, wobei die mechanische Komponente eine Komponente eines Wälzlagerkörpers oder einer Nabenlagereinheit ist.

12. Sensorelement nach einem der Ansprüche 1 bis 4, wobei das Substrat durch ein Material gebildet ist, das ein elektrischer Isolator ist.

13. Sensorelement nach einem der Ansprüche 1 bis 11, wobei das Substrat (200', 200", 300') als die zweite Elektrode des Sensorelements dient.

14. Sensorelement nach einem der vorhergehenden Ansprüche, wobei die empfindliche Schicht (204, 304) und die Nadellochabdichtungsschicht (206, 306) mittels einer reaktiven Zerstäubung aufgetragen sind.

15. Verfahren zur Herstellung eines Sensorelements nach einem der vorhergehenden Ansprüche, wobei das Sensorelement eine mehrlagige Beschichtung (202, 302), die auf ein Substrat aufgetragen ist, umfasst, wobei das Verfahren die folgenden Schritte umfasst:
(i) Auftragen einer empfindlichen Schicht (204, 304) eines piezoelektrischen Materials;
(ii) Auftragen einer Nadellochabdichtungsschicht (206, 306) auf die Oberseite der empfindlichen Schicht in einer Dicke kleiner als 10 % der Dicke der empfindlichen Schicht (204, 304);
(iii) Auftragen einer Elektrodenschicht (208, 308) auf die Oberseite der Nadellochabdichtungsschicht.

## Revendications

1. Élément capteur comprenant un revêtement multicouche déposé sur un substrat (200', 200", 300'), le revêtement multicouche (202, 302) comprenant une couche sensible (204, 304) d'un matériau piézoélectrique et une première couche d'électrode (208, 308) d'un matériau métallique, laquelle couche d'électrode sert de première électrode de l'élément capteur, la couche sensible étant située entre la première électrode et une deuxième électrode de l'élément capteur, **caractérisé en ce que** le revêtement multicouche (202, 302) comprend en outre une couche de scellement de trous d'épingle (206, 306) pour sceller tous les trous d'épingle dans la couche sensible (204, 304) et empêcher ainsi un court-circuit entre la première et la deuxième électrode, la couche de scellement de trous d'épingle (206, 306) étant d'un matériau diélectrique déposé par-dessus la couche sensible (204, 304) de manière à être intercalée entre la couche sensible et la première couche d'électrode (208, 308), la couche de scellement de trous d'épingle (206, 306) ayant une épaisseur inférieure à 10 % de l'épaisseur de la couche sensible (204, 304).

2. Élément capteur selon la revendication 1, dans lequel l'épaisseur de la couche de scellement de trous d'épingle (206, 306) est inférieure à 5 % de l'épaisseur de la couche sensible (204, 304).

3. Élément capteur selon la revendication 1 ou 2, dans lequel la couche sensible (204, 304) consiste en du nitrure d'aluminium ou de l'oxyde de zinc, déposé avec une orientation cristallographique se situant principalement dans l'axe c, ayant une épaisseur inférieure à 10 µm.

4. Élément capteur selon l'une quelconque des revendications précédentes, dans lequel la couche de scellement de trous d'épingle (206, 306) consiste en de l'oxyde d'aluminium.

5. Élément capteur selon l'une quelconque des revendications précédentes, dans lequel la couche sensible (204, 304) est déposée sur le substrat (200', 200", 300').

6. Élément capteur selon l'une quelconque des revendications 1 à 4, dans lequel le revêtement multicouche (202, 302) comprend en outre une couche de liaison métallique (301) déposée par-dessus le substrat (200', 200", 300') juste avant la couche sensible (204, 304).

7. Élément capteur selon l'une quelconque des revendications précédentes, dans lequel le substrat (200', 200", 300') est constitué d'un matériau qui est un conducteur électrique.

8. Élément capteur selon l'une quelconque des revendications précédentes, dans lequel le substrat (300') est une surface d'un support métallique en feuille (300) avec une épaisseur inférieure à 500 µm.

9. Élément capteur selon la revendication 8, dans lequel le support métallique en feuille (300) est constitué d'un matériau d'acier ne comprenant pas plus de 0,2 % en poids de carbone, ou de nickel ou d'un alliage de celui-ci, ou de titane ou d'un alliage de celui-ci.

10. Élément capteur selon l'une quelconque des revendications 1 à 7, dans lequel le substrat (200', 200") est formé par une surface ou des surfaces d'un composant mécanique.

11. Élément capteur selon la revendication 10, dans lequel le composant mécanique est un composant d'un palier d'élément roulant ou d'une unité de roulement de moyeu.

12. Élément capteur selon l'une quelconque des revendications 1 à 4, dans lequel le substrat est constitué d'un matériau qui est un isolant électrique.

13. Élément capteur selon l'une quelconque des revendications 1 à 11, dans lequel le substrat (200', 200", 300') sert de deuxième électrode de l'élément capteur.

14. Élément capteur selon l'une quelconque des revendications précédentes, dans lequel la couche sensible (204, 304) et la couche de scellement de trous d'épingle (206, 306) sont déposées par pulvérisation réactive.

15. Procédé de production d'un élément capteur selon l'une quelconque des revendications précédentes, l'élément capteur comprenant un revêtement multicouche (202, 302) déposé sur un substrat, le procédé comprenant les étapes consistant à :
(i) déposer une couche sensible (204, 304) d'un matériau piézoélectrique ;
(ii) déposer une couche de scellement de trous d'épingle (206, 306) par-dessus la couche sensible, dans une épaisseur inférieure à 10 % de l'épaisseur de la couche sensible (204, 304) ;
(iii) déposer une couche d'électrode (208, 308) par-dessus la couche de scellement de trous d'épingle.
